# EUROPEAN PATENT APPLICATION

(11) **EP 3 667 713 A1**
(43) Date of publication of application: **17.06.2020**
(21) Application number: 19210727.4
(22) Date of filing: 21.11.2019
(51) Int. Cl.: H01L 21/78

(54) **PLASMA CHEMICAL PROCESSING OF WAFER DIES**

(30) Priority: 13.12.2018 US 201816218533
(71) Applicant: ASM Technology Singapore Pte Ltd., Singapore 768924 (SG)
(72) Inventor: Evertsen, Rogier, 6845 KN Arnhem (NL); Beckers, Nicolle Maria Berta Jozefina, 6641 SH Beuningen (NL); Wang, Shaoying, 5629 GD Eindhoven (NL)
(74) Representative: Emerson, Peter James

(57) **Abstract**

A method of processing wafer dies at least partially separated by cut-lines formed in a surface of the wafer, comprises generating a plasma, for example using an RF source, and localising the reaction of the plasma with the wafer surface at vicinities of the cut-lines so as to etch the wafer in the vicinities of the cut-lines. Advantageously, the wafer may be laser-cut.

## Description

This invention relates to a method of processing wafer dies and a method of producing singulated wafer dies.

### Background and Prior Art

Singulation is a well-known process in the semiconductor industry, in which a cutting machine is used to work a workpiece or substrate such as a semiconductor wafer, which could for example comprise silicon but is not so limited. Throughout this specification, the term "wafer" is used to encompass all these products. In a singulation process (also referred to as dicing, severing, cleaving for example), a wafer, which will generally be mounted on a carrier tape supported by a frame, is completely cut through such as to singulate the wafer into individual dies.

Silicon semiconductor wafers are conventionally of the order of 0.005 mm to 1 mm thick. The traditional singulation method uses a diamond saw, which works well for thick wafers of thicknesses down to about 0.1 mm or 100µm, where physical constraints such as chipping, delamination and large kerf width are less demanding.

However, the overall semiconductor technology trend in miniaturization is to decrease the thickness of the wafer, and recently semiconductor manufacturers have started to migrate to the use of "thin" wafers, which will here be defined as wafers having a thickness of less than 100 µm.

As wafer thicknesses decrease, it has been shown that laser technology becomes more advantageous for singulation than the use of a mechanical saw. Exploiting high-power lasers for such material processing has significant advantages in comparison with mechanical counterparts such as, for instance, drilling and sawing, and laser processing has a great versatility in coping with small and delicate workpieces.

Laser removal of the semiconductor material occurs due to a rapid temperature increase of a relatively small area in which the laser beam is focused, which causes local material to melt, explosively boil, evaporate and ablate. Laser singulation has challenging requirements, including the delicate balance between the process throughput and the workpiece (die) quality. The quality and throughput of the process are determined by laser parameters such as fluence, pulse width, repetition rate and wavelength.

One of the quantitative assessments of the laser process quality is the die or wafer fracture strength, which determines a tensile stress at which the wafer breaks. Uniaxial flexure tests are commonly employed for the determination of fracture strength for brittle materials and have been adopted for wafer strength measurements. These tests include three- and four-point bending tests, which are commonly used to measure fracture strength.

It is believed that the fracture strength of the laser-separated wafers depends on the level of laser-induced defects such as micro-cracks and chip-outs present in the wafer. These defects are generated by a high stress at the interface between the bulk semiconductor material and the local laser-processed area, at the so-called "heat-affected zone" or HAZ. The high stress is produced by the rapid temperature increase in the processed area. The fracture strength is typically different for the front and back sides of the wafer.

In order to improve wafer strength, the laser-processed areas (i.e. cut regions or simply "cuts") are separately treated in order to anneal or remove defects. Currently-used post-treatment methods include wet etching and laser irradiation. This latter method, such as that described in US9312178, is particularly attractive since it potentially increases productivity and reduces costs.

Alternative techniques have been proposed, such as the use of plasma etching to separate dies, conveniently named plasma dicing, using dry reactive ion etching (DRIE) Bosch processing or similar processes, or specialised laser-based dicing techniques such as stealth dicing.

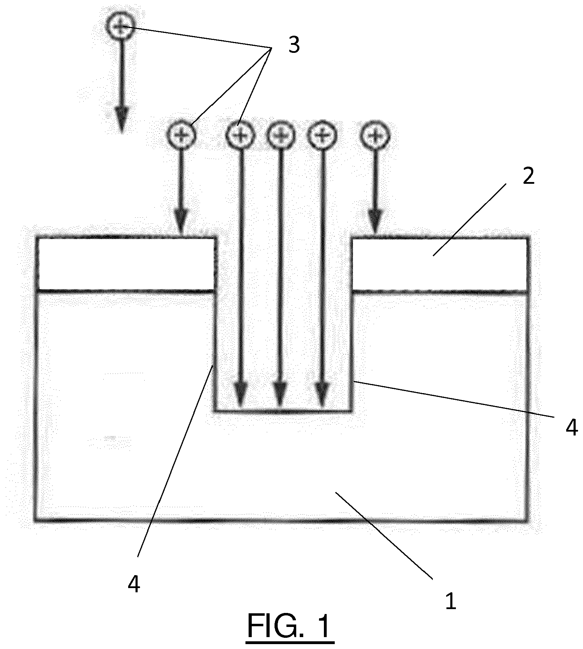

Current plasma dicing techniques require high vacuum and expensive tooling, and use highly directional, i.e. anisotropic, deep reactive-ion etching ("DRIE") processes such as the Bosch process (see for example US5501893) to achieve the desired separation. The application is typically limited in that, while silicon can be removed, top layers and backside metal layers need to be separated by other means. A DRIE-type process is schematically shown in FIG. 1, in which a wafer 1 to be cut is partially covered by a mask layer 2, such as a resist or hardened polymer coating. Ionic species 3 are directed anisotropically to the wafer 1, and therefore may create a relatively "clean" cut, since there is little impact of the ionic species at the sides 4 of the cut. Such techniques may therefore overcome the problem of lowered wafer strength due to defects, but as noted above these are generally expensive and complex.

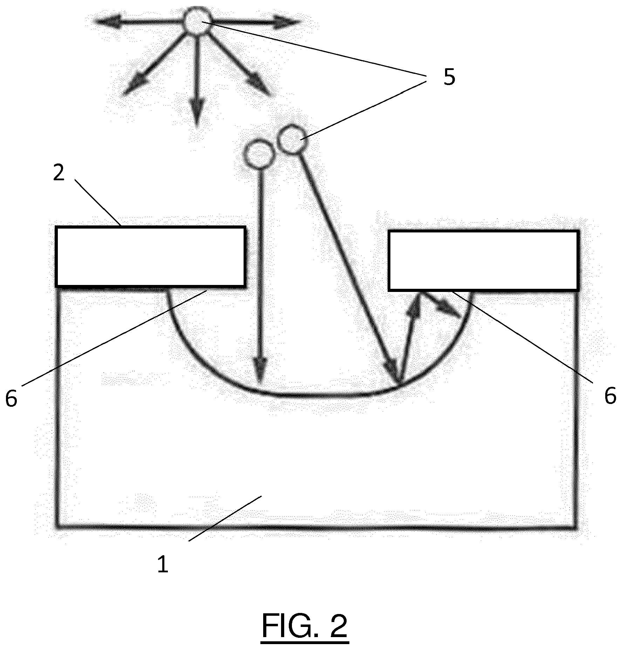

Another possible approach is the application of low energy plasma etching such as chemical dry etching, based on omnidirectional isotropic etching. A remote source is used (i.e. "remote plasma etching"), which may optionally be performed subsequent to a separate singulation technique, such as a laser-singulation technique, for scribing, grooving or separation. This application of chemical plasma typically makes use of microwave sources, which require high flow and power. The process settings typically result in clear isotropic etching and a high thermal load. It has been found that this results in undesired undercutting and damage to top surfaces due to the accelerated etching of top layers. Such an approach is schematically illustrated in FIG. 2, where a wafer 1 and polymer coating mask 2, similar to those of FIG. 1 are shown, here being exposed to reactive neutral species or radicals 5 during a chemical plasma etching process. It can be seen that the isotropic nature of the etching creates an undercut region 6, where wafer material underneath the mask layer 2 is removed.

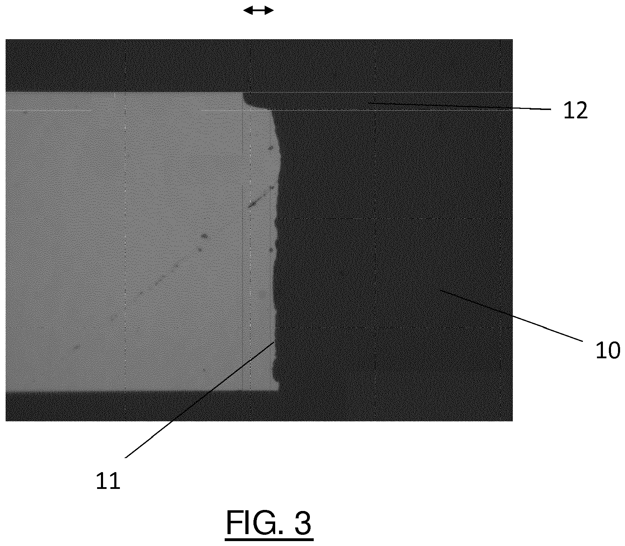

A microscope image of an actual wafer subjected to processing by chemical dry etching is shown in FIG. 3. Here, a wafer 10 has been singulated using a laser process, so that the wafer 10 has a sidewall 11 defining a cut-line. It can be seen that in the region of the cut-line, the wafer's polymer coating mask layer 12 overhangs the sidewall 11, as shown by the arrow, here by 6.8 µm. In other words, the wafer 10 has a 6.8 µm undercut, which may be unacceptably large for certain applications.

It is an aim of the present invention to overcome these problems, and provide a methodology for providing singulated wafers of high strength and reduced damage, which uses low power and an apparatus having relatively low complexity.

More particularly, it is an aim of the present invention to seek to provide a processing method and system which:
- produces minimum thermal impact, thus minimizing damage caused by etching;
- enables the use of laser coating, i.e. coatings conventionally used to protect wafers during laser processes, as a protective mask film;
- enables chemical etching without the undercut resulting from purely isotropic etching as normally achieved using microwave sources; and
- utilises isotropic etching, thus enabling sidewall etching (as opposed to plasma dicing techniques which are highly directional).

In accordance with the present invention this aim is achieved by applying a chemical etching process created using an RF-source plasma to a wafer, subsequent to a laser cutting process. The RF-source plasma exhibits isotropy, and therefore is able to remove the HAZ from the sidewalls of the groove or cut, however there remains some directionality (anisotropy), and so the production of an undercut is reduced as compared to known, fully isotropic methods.

### Summary of the Invention

In accordance with a first aspect of the present invention there is provided a
method of processing wafer dies, comprising the steps of:
placing a wafer in a chamber, the wafer comprising a plurality of wafer dies at least partially separated by cut-lines formed in a surface of the wafer,
generating a plasma inside the chamber, and
localising the reaction of the plasma with the wafer surface at vicinities of the cut-lines so as to etch the wafer in the vicinities of the cut-lines.

In accordance with a second aspect of the present invention there is provided a method of producing singulated wafer dies, comprising the steps of:
using a laser to cut a wafer at a surface thereof to produce a plurality of individual wafer dies at least partially separated by cut-lines, and
etching the wafer dies using the method of the first aspect, to remove recast material from the wafer dies, the recast material being created by the laser-cutting of the wafer.

Other specific aspects and features of the present invention are set out in the accompanying claims.

### Brief Description of the Drawings

The invention will now be described with reference to the accompanying drawings (not to scale), in which:
FIG. 1 schematically shows a DRIE-type anisotropic process;
FIG. 2 schematically shows an isotropic remote plasma etching process;
FIG. 3 is a microscope image of an actual wafer processed in accordance with a prior art plasma processing technique;
FIG. 4 is a flowchart schematically setting out the main stages of a wafer singulation process in accordance with an embodiment of the present invention;
FIG. 5 schematically shows a sectional view of a grooved wafer;
FIG. 6 schematically shows a sectional view of a scribed wafer;
FIG. 7 schematically shows a sectional view of a diced wafer;
FIG. 8 schematically shows a sectional side view of a wafer mounted for plasma etching within a plasma etching machine;
FIG. 9 schematically shows the grooved wafer of FIG. 5 after etching;
FIG. 10 schematically shows the diced wafer of FIG. 7 after etching; and
FIG. 11 is a microscope image of an actual wafer processed in accordance with the present invention.

### Detailed Description of the Preferred Embodiments of the Invention

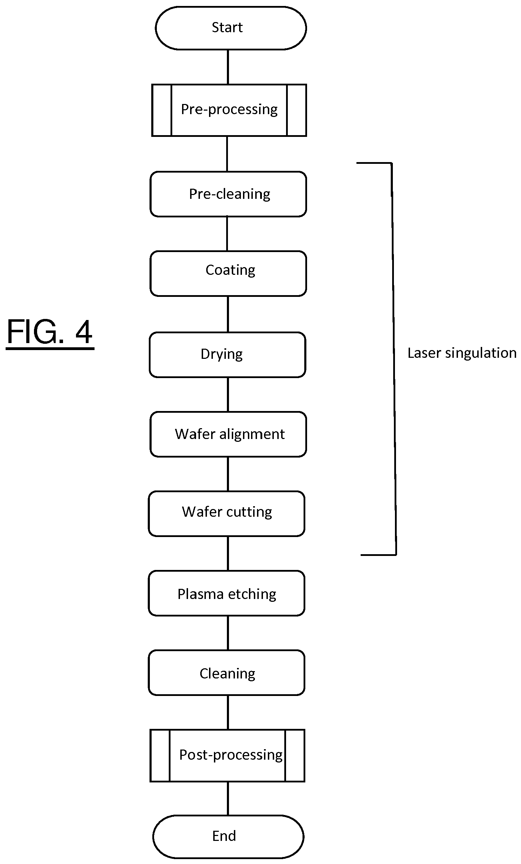

A flowchart schematically setting out the main stages of a semiconductor wafer singulation process in accordance with an embodiment of the present invention is shown in FIG. 4. As shown in FIG. 4, the exemplary singulation process may be summarised by the following steps:

### i) Pre-processing

It is known and conventional that some pre-processing is performed before singulation, and so this will not be described in detail. At the end of pre-processing, the semiconductor wafer will be mounted on a tape which is supported by a frame.

The pre-processing step is then followed by a laser singulation procedure, which, as is known in the art, includes the following main process steps:

### ii) Pre-cleaning

The wafer is cleaned to ensure high quality coating in the next step.

### iii) Coating

The cleaned wafer has a protective polymer coating applied to its upper surface.

### iv) Drying

The applied polymer coating is dried before further processing can be performed.

### v) Wafer alignment

The wafer, still mounted on tape supported within a frame, is placed into a laser-cutting machine, and accurately aligned to ensure corresponding accuracy of the laser cutting. The wafer will generally be supported on a chuck within the machine, with the chuck being relatively movable with respect to the laser optics. Usually the chuck is arranged to move while the laser optics are held stationary, but this is not essential, and the laser optics may be adapted to move with the chuck either being held stationary or also adapted for movement.

### vi) Wafer cutting

Following alignment, the laser-cutting machine is operated to at least partially cut the wafer along a plurality of cut-lines or "dicing streets". As noted above, typically the chuck is movable with respect to the laser optics, with the movement being carefully controlled so that the laser beam illumination spot accurately follows the intended cut-lines. It is also possible to illuminate the wafer using an array of laser beam spots, for example using a diffractive optical element (DOE) to split a main output laser beam into a plurality of sub-beams, which are directed to the wafer. The laser is operable to remove the polymer coating during the cutting process.

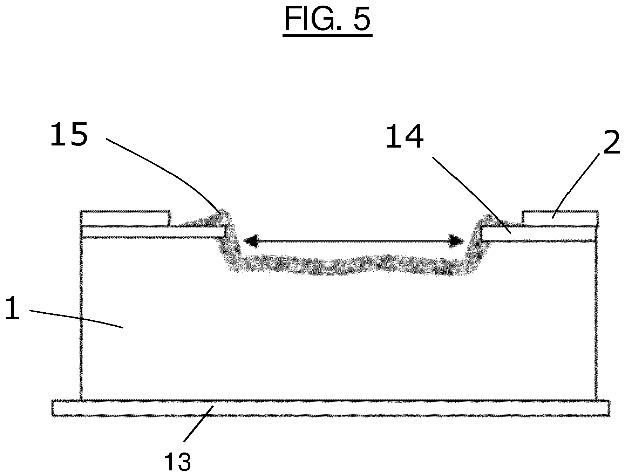

There are three main singulation approaches possible: grooving, scribing and dicing. Sectional views of wafers which have been grooved, scribed and diced are respectively illustrated in FIGs. 5 to 7. In all of these figures, a semiconductor wafer 1 is mounted on a carrier tape 13, and the top surface of the wafer outside the cut-line is covered by polymer coating 2. An active layer 14 is very schematically shown in the upper region of the wafer 1, which may predominantly comprise, for example a combination of metal, silicon nitride (SiN) and SiO₂. The ablating action of the laser on the wafer causes the formation of recast material 15 around the ablated region. Although not shown in these figures, there may typically be debris deposited on the wafer 1, which debris is a side-effect of the laser-cutting. Grooving, schematically shown in FIG. 5, comprises creating a relatively wide channel in a wafer 1 along a cut-line, with the width of the kerf, shown by the arrow, typically being around 40µm. As shown in FIG. 5, the grooving may result in a heat-affected zone of recast material 15 which at least partially extends both below and above the wafer's active layer 14.

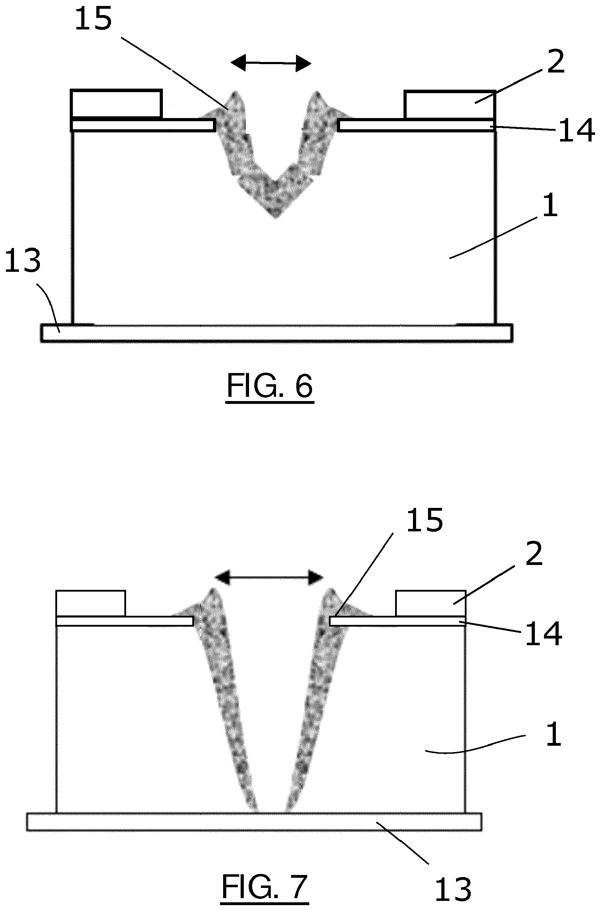

Scribing, schematically shown in FIG. 6, comprises creating a narrower channel in the wafer, with the width of the kerf typically being around 8µm.

Dicing, schematically shown in FIG. 7, is similar to scribing, but the cut is continued throughout the entire depth of the wafer, so that the tape 13 is exposed. This results in a kerf width typically around 12µm.

This completes the laser singulation process.

### vii) Plasma etching

Following laser singulation, in accordance with the present invention, plasma etching is performed to remove recast and damage to the active and base wafer material. Advantageously, the laser-cutting machine could be equipped with plasma-generating apparatus, in which case the singulated wafer may be plasma etched within the same machine, however this is not essential, and the wafer, still mounted on the carrier tape, may be moved to a separate, dedicated machine for plasma etching. The wafer is first placed in the machine's plasma chamber mounting assembly.

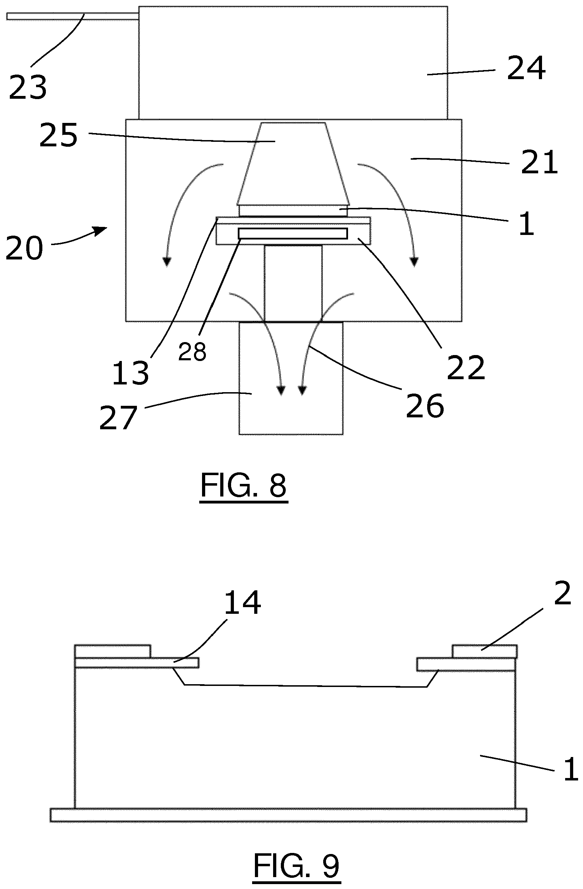

FIG. 8 schematically shows a sectional side view of a singulated wafer 1 mounted for plasma etching within a plasma chamber 21 of a dedicated plasma etching machine 20. The wafer 1 remains mounted on the carrier tape 13 and its associated frame (not shown), and held on a chuck 22, for example by vacuum clamping, as is generally known in the art. In this embodiment, the chuck 22 comprises temperature regulating means 28, such that the temperature of the chuck 22 may be controlled by a control means (not shown) such as a processor, computer or the like. The temperature regulating means 28 may, for example, comprise refrigerant or heated fluid transfer tubing in thermal communication with the chuck 22, resistive heating elements embedded within the chuck 22, infra-red lamps or the like.

Once mounted on the chuck 22, plasma etching can commence. Gas is supplied via a gas supply 23 to an RF plasma source 24, which generates active species. A suitable process is described for example in US-9386677-B1. Using such an RF plasma source design enables high radical density through efficiency and a low number of energetic ions. The RF plasma source design enables low flow, low power and low pressure processing conditions. Exemplary processes include:

CF₄ + O₂ -> 4F* + CO + other

These plasma-generated species 25 are directed to the surface of the wafer 1 due to a pressure gradient formed within the plasma chamber. In this way, the reaction of the plasma with the wafer surface may be localised at vicinities of the cut-lines, creating a chemical etch of the wafer 1 in the vicinities of the cut-lines, for example:

Si + 4F -> SiF₄ (g)

Unreacted species, as well as waste products 26 flow out of the machine via an exhaust 27. The polymer coating on the upper surface of the wafer 1 acts as a mask layer for the plasma, the mask layer having respective openings at the cut-lines, formed by the laser cutting process, which enable the generated plasma to pass through, allowing the plasma to etch the wafer 1 in the region of the cut-lines, but preventing etching in other regions of the wafer spaced from the cut-lines.

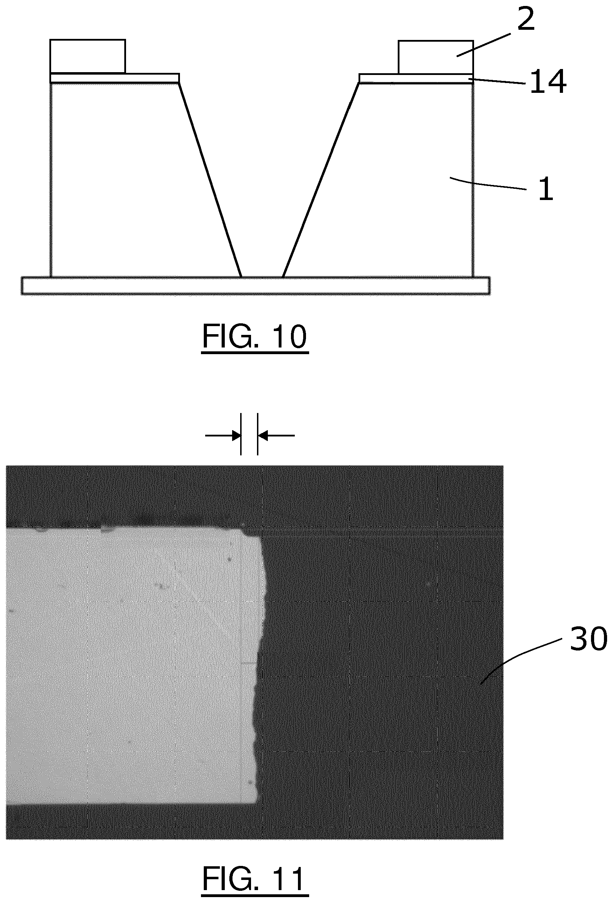

The effect of this plasma-created chemical etch on the wafer 1 is schematically shown in FIG. 9, where a grooved wafer (such as that shown in FIG. 5 before etching) is shown after the etching, and FIG. 10, where a fully diced wafer (such as shown in FIG. 7 before etching) is shown after the etching. Looking firstly at FIG. 9, it can be seen that the etching can successfully remove all recast material, including that located on top of, and underlying, the active layer 14. This is possible because the plasma etching shows isotropy, and therefore will act on the sidewalls of the cut. In contrast, known DRIE-like processes, which are anisotropic, would not be able to remove recast material underlying the active layer 14 or polymer coating 2. It should be noted though that while the plasma etching is isotropic, it is not fully isotropic, and so does exhibit some directionality, and will therefore strongly etch the bottom of the cut. This is advantageous for example when etching diced wafers, as shown in FIG. 10, where again all recast material is removed. In addition, the anisotropy reduces overhang of the polymer coating layer, as will be described below with reference to FIG. 11.

### viii) Cleaning

After the plasma etching is complete, the wafer dies may be cleaned to remove surface debris, using conventional cleaning techniques.

### ix) Post-processing

Following the above steps, the processed wafer dies may be subjected to post-processing steps as required for the specific application, as is understood in the art.

The methodology of the present invention has been found to produce beneficial effects in practice. FIG. 11 is a microscope image of an actual wafer 30 processed in accordance with the present invention, which may be compared directly with that of FIG. 3, where a fully isotropic chemical dry etching technique was used. While the wafer of FIG. 3 had an overhang of the polymer coating layer of 6.8 µm, the wafer of FIG. 11 has an overhang of only 4.5 µm, which is a significant reduction. This is attributable to the partial anisotropy exhibited by the plasma etching of the present invention.

In addition, the polymer coating layer is undamaged by the plasma etching, and so this permits the possibility of using the coating as a mask for the plasma processing.

The above-described embodiments are exemplary only, and other possibilities and alternatives within the scope of the invention will be apparent to those skilled in the art. For example, while the above embodiments use a polymer coating, other forms of coating material may be used, and for some applications the coating may be optional. In this case, a dedicated mask for the plasma, such as a so-called "hard mask" may be applied before etching. While the present invention is particularly beneficial for etching wafers which have previously been laser-cut, which includes grooving, scribing or laser full-cut, the invention is not so limited, and the plasma etching may be applied to wafers cut by other methods, for example using a mechanical cutting means such as a saw or wafer scribing using a diamond tip.

### Reference numerals used:

1 - Wafer
2 - Mask
3 - Ionic species
4 - Sidewalls
5 - Reactive neutral species
6 - Undercut
7 - Sidewall
10 - Wafer
11 - Sidewall
12 - Coating
13 - Tape
14 - Active layer
15 - Recast material
20 - Plasma etching machine
21 - Plasma chamber
22 - Chuck
23 - Gas supply
24 - RF plasma source
25 - Plasma-generated species
26 - Flow of species and products
27 - Exhaust
28 -Temperature regulating system
30 - Wafer

## Claims

1. A method of processing wafer dies, comprising the steps of:
placing a wafer in a chamber, the wafer comprising a plurality of wafer dies at least partially separated by cut-lines formed in a surface of the wafer,
generating a plasma inside the chamber, and
localising the reaction of the plasma with the wafer surface at vicinities of the cut-lines so as to etch the wafer in the vicinities of the cut-lines.

2. The method of claim 1, wherein the plasma is generated using an RF source.

3. The method of claim 1, wherein the wafer is provided on a chuck incorporating a temperature regulating system located in the chamber, and the method further comprises the step of controlling the temperature of the chuck.

4. The method of claim 1, wherein the wafer dies have been fully separated by singulation when placed in the chamber.

5. The method of claim 1, wherein the wafer dies comprise recast material adjacent the cut-lines, and the species are operative to chemically etch the recast material.

6. The method of claim 1, wherein the cut-lines comprise groove lines.

7. The method of claim 1, wherein the cut-lines comprise scribe lines.

8. The method of claim 1, wherein the cut-lines comprise dicing lines.

9. The method of claim 1, wherein the wafer comprises a semiconductor wafer.

10. The method of claim 1, wherein the wafer is provided with a mask layer on the surface, the mask layer having respective openings at the cut-lines to enable the generated plasma to pass through to the wafer surface for etching.

11. The method of claim 9, wherein the mask layer comprises a polymer coating.

12. A method of producing singulated wafer dies, comprising the steps of:
using a laser to cut a wafer at a surface thereof to produce a plurality of individual wafer dies that is at least partially separated by cut-lines, and
etching the wafer dies using the method of claim 1, to remove recast material from the wafer dies, the recast material having been created when the laser is used to cut the wafer.

13. The method of claim 12, comprising an initial step of applying a polymer coating to the wafer surface,
wherein, during the etching step, the polymer coating acts as a mask, allowing the plasma to etch the wafer in the region of the cut-lines, but preventing etching in other regions of the wafer.
